# EUROPEAN PATENT SPECIFICATION

(11) **EP 1 474 542 B1**
(45) Date of publication and mention of the grant of the patent: **13.05.2009**
(21) Application number: 03707466.3
(22) Date of filing: 21.01.2003
(51) Int. Cl.: C23C 14/04, H01L 21/02

(54) **Method of CIRCUIT FABRICATION using an aperture mask**
Verfahren FÜR DIE HERSTELLUNG VON SCHALTKREISEN unter Verwendung einer Lochmaske
Procédé POUR LA FABRICATION DE CIRCUITS utilisant un masque perforé

(30) Priority: 14.02.2002 US 76003
(43) Date of publication of application: 10.11.2004
(60) Divisional application: 08021822.5
(73) Proprietor: 3M Innovative Properties Company, St. Paul MN 55133-3427 (US)
(72) Inventor: BAUDE, Paul, F., Saint Paul, MN 55133-3427 (US); FLEMING, Patrick, R., Saint Paul, MN 55133-3427 (US); HAASE, Michael, A., Saint Paul, MN 55133-3427 (US); KELLEY, Tommie, W., Saint Paul, MN 55133-3427 (US); MUYRES, Dawn, V., Saint Paul, MN 55133-3427 (US); THEISS, Steven, Saint Paul, MN 55133-3427 (US)
(74) Representative: Vossius & Partner
(86) International application number: PCT/US2003/001751
(87) International publication number: WO 2003/069014

(56) References cited:
- EP-A- 1 036 858
- US-A- 5 154 797
- US-A1- 2002 111 035

## Description

### TECHNICAL FIELD

The invention relates to methods of making transistors and integrated circuits according to claims 1-8.

### BACKGROUND

Circuits include combinations of resistors, diodes, capacitors and transistors linked together by electrical connections. Thin film integrated circuits include a number of layers such as metal layers, dielectric layers, and active layers typically formed by a semiconductor material such as silicon. Typically, thin film circuit elements and thin film integrated circuits are created by depositing various layers of material and then patterning the layers using photolithography in an additive or subtractive process, which includes a chemical etching step to define various circuit components. Additionally, aperture masks have been used to deposit a patterned layer without an etching step.

### SUMMARY

In general, the invention is directed to aperture mask deposition techniques for use in creating integrated circuits or integrated circuit elements. The techniques involve sequentially depositing material through a number of repositionable aperture masks formed with patterns of vias that define layers, or portions of layers of the circuit. In some embodiments, circuits can be created solely using aperture mask deposition techniques, without requiring any of the etching or photolithography steps typically used to form integrated circuit patterns. The techniques can be particularly useful in creating circuit elements for electronic displays such as liquid crystal displays and low-cost integrated circuits such as radio frequency identification (RFID) circuits or electronic memory. In addition, the techniques can be advantageous in the fabrication of integrated circuits incorporating organic semiconductors, which typically are not compatible with photolithography or other wet etching processes.

In an embodiment, the invention is directed to a method of making an integrated circuit according to claim 1. For example, the integrated circuit may include a deposition substrate, a first patterned electrode layer formed adjacent to the substrate, an organic semiconductor layer formed adjacent to the first electrode layer, and a second patterned electrode layer deposited adjacent to the organic semiconductor layer. The first patterned electrode layer may define a gate electrode, and the second patterned electrode layer may define source and drain electrodes, wherein at least one of the electrodes has a width less than approximately 20 µm (microns), less than approximately 10 µm (microns), or even less than approximately 5 µm (microns). Alternatively, the first patterned electrode layer may define source and drain electrodes, and the second patterned electrode layer may define a gate electrode. The integrated circuit may further include a dielectric layer formed over the gate electrode and under the organic semiconductor layer. Each of the above-described layers of the integrated circuit can be patterned, wherein the patterns of each layer are defined by an aperture mask. Additionally, the gap between the electrodes may be less than 20 µm (microns), or even less than 10 µm (microns) which can be particularly useful in creating small circuit elements or closely spaced circuit elements. The integrated circuit may also include one or more interconnect layers as well as interconnects formed as part of other metal layers, for example, by implementing stitching techniques of successive aperture mask depositions. The integrated circuit may form part of an electronic display, an RFID circuit or an electronic memory.

In another embodiment, the invention is directed to a method of making a transistor according to claim 6. For example, the transistor may form part of an integrated circuit such as an RFID circuit, or alternatively, the transistor may form a control element for a pixel of a display such as an LCD display. The transistor may include a first deposited conductive layer, a deposited dielectric layer formed over the deposited conductive layer, a deposited organic semiconductor layer formed over the deposited dielectric layer, and a second deposited conductive layer formed over the deposited organic semiconductor layer. At least one layer may define at least one feature having a width less than approximately 20 µm (microns), 10 µm (microns), or even 5 µm (microns).

An integrated circuit may include a number of deposited layers, wherein none of the layers are etched, and wherein at least one of the layers defines features having widths less approximately than 20 µm (microns), less approximately than 10 µm (microns), or even less approximately than 5 µm (microns). Integrated circuits can be particularly useful when organic semiconductors are implemented because no etching or photolithography is required in the circuit fabrication process according to the invention. For example, the aperture mask deposition techniques described herein can facilitate the creation of circuits without using etching or photolithographic techniques. Again, this is particularly useful for circuits that use organic semiconductors because chemical etching and/or photolithographic techniques generally are not compatible with patterning of organic semiconductors. The organic semiconductors used may be polycrystalline, such as pentacene. In addition, aperture masks having deposition apertures of widths on the order of those discussed herein can facilitate the creation of circuits having small circuit elements in a simple and relatively low cost vapor deposition process. Also, deposition apertures separated by gaps on the order of these discussed herein can also facilitate the creation of smaller circuit elements. Still, the aperture masks described herein are durable and thus can be reused a number of times. Furthermore, non-metallic aperture masks may be less prone to the formation of creases which can render thin metal masks unusable.

The alignment techniques described herein can be highly advantageous to quickly and effectively align deposition masks for the deposition process. In particular, the formation of alignment edges on the mask avoids the need for registration holes and posts, which may introduce slight clearances that permit movement and can result in misalignment. Moreover, for non-metallic masks, the use of registration holes and posts can cause damage to the mask, particularly as efforts are made to provide a tight fit that reduces clearances in the holes. Accordingly, the use of alignment edges can be more effective in aligning the aperture mask than registration holes. In some cases, the use of alignment edges may facilitate mechanical alignment of an aperture mask with a deposition substrate to within a tolerance less than approximately 10 µm (microns), less than approximately 5 µm (microns), or even less than approximately 2 µm (microns). Mask damage can be avoided and precise alignment can be falicitated for the formation of circuits created in the deposition process.

Details of these are set forth in the accompanying drawings and the description below. Other features, objects, and advantages will become apparent from the description and drawings, and from the claims.

### BRIEF DESCRIPTION OF DRAWINGS

FIG. 1a is a top view of an aperture mask.
FIG. 1b is an enlarged view of a portion of the aperture mask in FIG 1a.
FIG 2 is a top view of an exemplary mask set.
FIG 3 is simplified block diagram of a deposition station that can use aperture masks.
FIGS. 4 and 5 are cross-sectional views of exemplary thin film transistors that can be created according to the invention.
FIG. 6 is a top view of an aperture mask having alignment edges and a pattern defined in relation to the alignment edges.
FIG. 7 is a top view of deposition substrate having alignment edges that substantially correspond to the alignment edges of the aperture mask of FIG. 6.
FIG. 8 is a perspective view of an alignment fixture.
FIG. 9 is a top view of an embodiment of the alignment fixture.
FIG. 10 is simplified a block diagram of a deposition station.
FIGS. 11-13 are flow diagrams.

### DETAILED DESCRIPTION

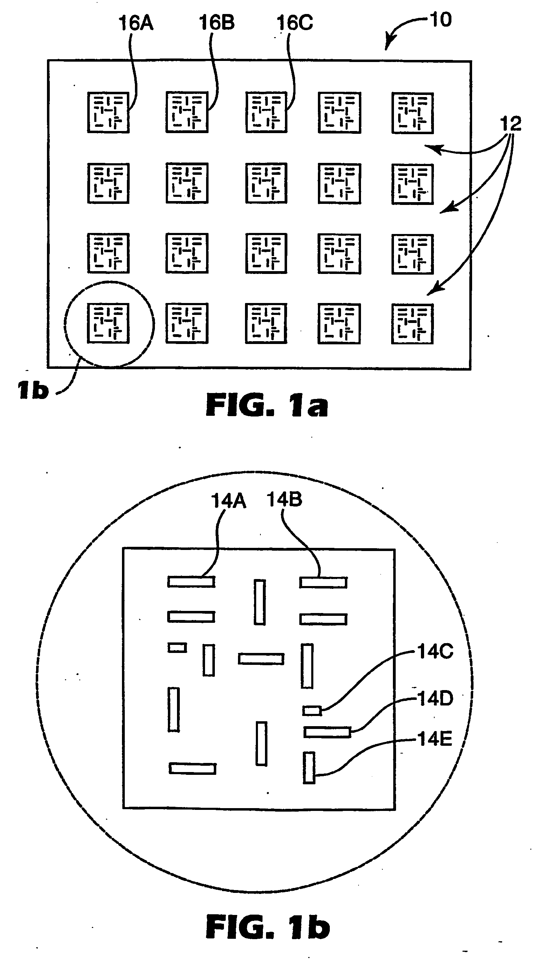

FIG. 1a is a top view of an aperture mask. Aperture mask 10 can comprise any of a variety of metallic or non-metallic materials. Non-metallic materials may be particularly useful for some embodiments. For example, aperture mask 10 may comprise single crystal silicon, rigid polymer or filled polymer substrates, glass, or the like. In the case of silicon, aperture mask 10 may have a thickness of less than approximately 100 µm (microns), or even less than 50 µm (microns). Such thicknesses of silicon can be effective for use in deposition techniques for circuit fabrication. Moreover, aperture mask 10 formed from non-metallic material can yield advantages over conventional metallic masks such as lower cost formation and better resolution of a deposition pattern. Aperture mask 10 is free-standing in that it forms a separate and distinct structure that does not form part of a deposition substrate. Aperture mask 10 is reusable in a number of deposition processes.

As shown in FIGS. 1a and 1b, aperture mask 10 is formed with a pattern 12 that defines a number of deposition apertures 14 (only deposition apertures 14A-14E are labeled). The arrangement and shapes of deposition apertures 14A-14E in FIG. 1b are simplified for purposes of illustration, and are subject to wide variation according to the application and circuit layout envisioned by the user. Pattern 12 defines at least a portion of a circuit layer and may generally take any of a number of different forms. In other words, deposition apertures 14 can form any pattern, depending upon the desired circuit elements or circuit layer to one created in the deposition process using aperture mask 10. For example, although pattern 12 is illustrated as including a number of similar sub-patterns (sub-patterns 16A-16C are labeled). In some cases, each sub pattern defines a portion of a circuit that is deposited in a single deposition. In that case, pattern 12 defines the pattern for the single deposition, with sub-patterns possibly defining a similar repeated pattern. However, in other cases, each sub pattern 16 may define a sub-mask for the deposition process. In the latter case, sequential depositions may be performed through each sub-pattern 16. Thus, in the later case, different layers of a circuit may be deposited by realigning aperture mask 10 such that each sub-pattern can be used for sequential depositions.

Aperture mask 10 can be used in a deposition process, such as a vapor deposition process in which material is deposited onto a deposition substrate through deposition apertures 14 to define at least a portion of a circuit. Advantageously, aperture mask 10 enables deposition of a desired material and, simultaneously, formation of the material in a desired pattern. Accordingly, there is no need for a separate patterning step preceding or following deposition. Aperture mask 10 can be particularly useful in creating circuits in electronic displays, low-cost integrated circuits such as RFID circuits, or any circuit that implements thin film transistors.

One or more deposition apertures 14 can be formed to have widths less than approximately 20 µm (microns) less than approximately 10 µm (microns), or even less than approximately 5 µm (microns). By forming deposition apertures 14 to have widths in these ranges, the size of circuit elements may be reduced. Moreover, a distance (gap) between two deposition apertures (such as for example the distance between deposition aperture 14C and 14D) may be less than approximately 20 µm (microns) or less than approximately 10 µm (microns), to reduce the size of various circuit elements and possibly improve performance.

If aperture mask 10 is formed from a silicon wafer, the pattern 12 of deposition apertures 14 can be created using reactive ion etching or laser ablation techniques to achieve acceptable widths of deposition apertures 14 as well as acceptable gaps between deposition apertures 14. Alternatively, if aperture mask 10 is formed from another non-metallic material, such as a polymer, laser ablation techniques or micro-replication techniques such as micro-molding may be used to define pattern 12 of deposition apertures 14. Accordingly, formation of aperture mask 10 from non-metallic materials may allow the use of fabrication processes that can be less expensive, less complicated, and/or more precise than those generally required for metallic masks. When an aperture mask is fabricated, for example, by creating deposition pattern 12 in a crystalline wafer, the straight edges of the deposition apertures may be purposely misaligned with respect to cleavage planes or crystallographic axes of the wafer. If the straight edges of the apertures are aligned with the crystallographic axes, the mask may be prone to breakage. Such misalignment would also be useful in aperture masks made from crystalline wafers, including for example, wafers comprising single crystal silicon, Ge or GaAs. The angle of misalignment may be five degrees or greater.

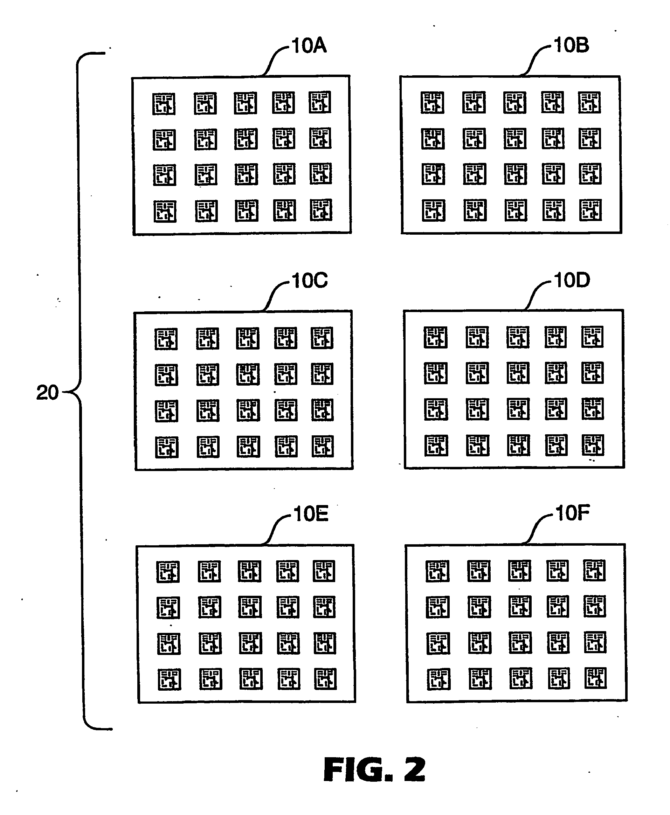

FIG 2 is a top view of a mask set 20 that includes a number of aperture masks 10A-10F for use in a deposition process. Mask set 20 may include any number of aperture masks, depending on the circuit or circuit element to be created in the deposition process. Masks 10A-10F form a "set" in the sense that each mask may correspond to a particular layer or set of circuit elements within on overall integrated circuit. Each aperture mask 10 can be formed with a pattern of deposition apertures that define at least part of a layer of a circuit. For example, a first aperture mask 10A may be formed with a first pattern of deposition apertures that define at least part of a first deposition layer of a circuit, while a second aperture mask 10B may be formed with a second pattern of deposition apertures that define at least part of a second deposition layer of the circuit. In other words, each mask 10 in mask set 20 may form only part of any given circuit layer. The mask set is used to create a wide variety of integrated circuits, such as integrated circuits which include one or more complimentary transistor circuit elements such as a complimentary metal oxide semiconductor (CMOS) element. The complimentary transistor circuit element may include a semiconductor layer comprising amorphous silicon. Organic, inorganic, or organic/inorganic hybrid semiconductor materials may also be used. For some circuits, both organic and inorganic semiconductors may be used.

In some cases, the first and second aperture masks 10A and 10B may define different layers of a circuit, and in other cases, first and second aperture masks 10A and 10B may define different portions of the same circuit layer or may define parts of other layers. For example, stitching techniques can be used to form interconnects in which first and second aperture masks 10A and 10B define different portions of the same circuit layer. In other words, two or more masks may be used in separate depositions to define a single circuit layer, which may include one or more interconnects. Stitching techniques can be used, for example, to avoid relatively long deposition apertures, closed curves, or patterns that could cause portions of the aperture masks to be poorly supported. The solution is to form long lines and closed curves by "stitching" together the deposition patterns associated with two or more aperture masks to define a single circuit feature. In a first deposition, one mask forms part of a feature, and in a second deposition, another mask forms the remainder of the feature.

Each aperture mask 10 in mask set 20 can be formed with one or more deposition apertures having widths less than approximately 20 µm (microns), less than approximately 10 µm (microns), or even less than approximately 5 µm (microns). In addition, at least two deposition apertures in each aperture mask may be separated by a gap less than approximately 20 µm (microns), or less than approximately 10 µm (microns). Again, apertures and aperture gaps of these dimensions can reduce circuit size, and in some cases improve circuit performance.

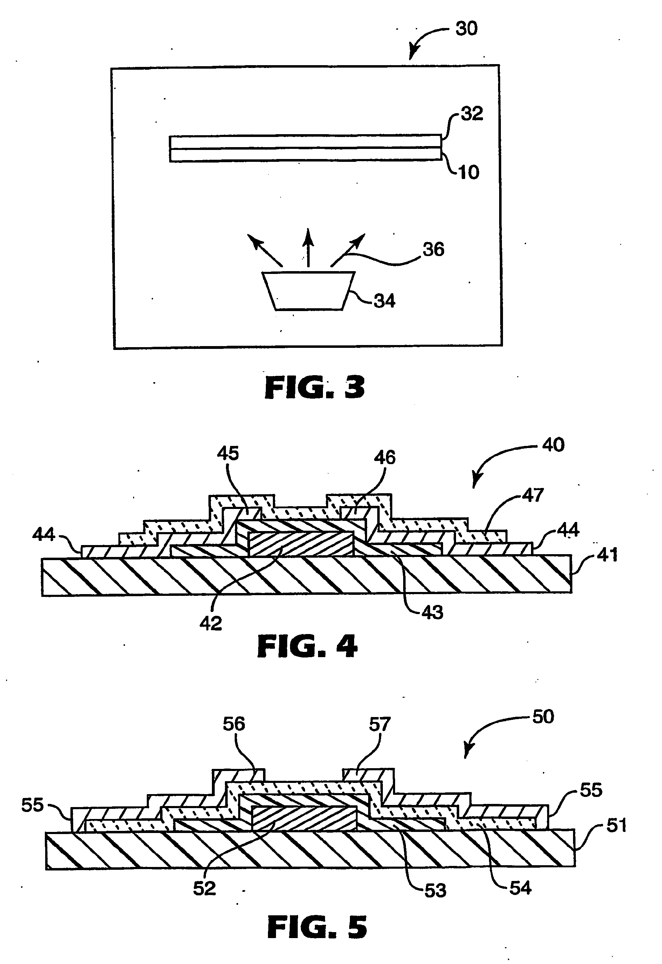

FIG. 3 is simplified block diagram of a deposition station that can use aperture masks in a deposition process according to the invention. In particular, deposition station 30 can be constructed to perform a vapor deposition process in which material is vaporized and deposited on a deposition substrate through an aperture mask. The deposited material may be semiconductor material, dielectric material, or conductive material used to form a variety of elements within an integrated circuit. In some cases, the deposited material may comprise an organic semiconductor, an inorganic semiconductor, pentacene, and/or amorphous silicon. Aperture mask 10 is placed in proximity with a deposition substrate 32. For example, in some cases, it can be advantageous to place aperture mask 10 into intimate contact with deposition substrate 32, and in other cases a small gap between deposition substrate 32 and aperture mask 10 can improve the deposition process. Deposition substrate 32 may comprise any of a variety of materials depending on the desired circuit to be created. For example, if the desired circuit is a RFID circuit, deposition substrate 32 may comprise a flexible material, such as a flexible polymer. Additionally, if the desired circuit is a circuit of transistors for an electronic display, deposition substrate 32 may comprise the backplane of the electronic display. Other deposition substrates such as glass substrates, silicon substrates, rigid plastic substrates, metal foils coated with an insulating layer, or the like, could also be used.

Deposition station 30 is typically a vacuum chamber. After aperture mask 10 is placed into intimate contact with deposition substrate 32, material 36 is vaporized by deposition unit 34. For example, deposition unit 34 may include a boat of material that is heated to vaporize the material. The vaporized material 36 deposits on deposition substrate 32 through the deposition apertures of aperture mask 10 to define at least a portion of a circuit layer on deposition substrate 32. Upon deposition, material 36 forms the pattern defined by aperture mask 10. As mentioned above, aperture mask 10 may include deposition apertures and gaps that are sufficiently small to facilitate the creation of small circuit elements using the deposition process. Additionally, various alignment techniques may be used as described in greater detail below, to ensure that the aperture mask is properly aligned during the deposition process. Specifically, each aperture mask in the mask set may need to be similarly aligned for the sequential deposition process through each mask in the set. Other suitable deposition techniques include e-beam evaporation, various forms of sputtering, and pulsed laser deposition.

FIGS. 4 and 5 are cross-sectional views of exemplary thin film transistors that can be created according to the invention. In accordance with the invention, thin film transistors 40 and 50 are created without using any etching or lithography techniques. Instead, thin film transistors 40 and 50 are created solely using aperture mask deposition techniques as described herein. Importantly, the aperture mask deposition techniques achieve sufficiently small circuit features in the thin film transistors. In addition, if an organic semiconductor is used, the invention can facilitate the creation of thin film transistors in which the organic semiconductor is not the top-most layer of the circuit. Rather, in the absence of chemical etching and/or photolithography, electrode patterns may be formed over the organic semiconductor material. This advantage of aperture mask 10 can be exploited while at the same time achieving acceptable sizes of the circuit elements.

Thin film transistors are commonly implemented in a variety of different circuits, including for example, RFID circuits and other low cost circuits. In addition, thin film transistors can be used as control elements for liquid crystal display pixels, or other flat panel display pixels. Many other applications for thin film transistors also exist.

As shown in FIG. 4, thin film transistor 40 is formed on a deposition substrate 41. Thin film transistor 40 represents one embodiment of a transistor in which all of the layers are deposited using an aperture mask and none of the layers are formed using etching or lithography techniques. The aperture mask deposition techniques described herein can enable the creation of thin film transistor 40 in which a distance between the electrodes is less than approximately 20 µm (microns), or even less than approximately 10 µm (microns), while at the same time avoiding conventional etching or photolithographic processes.

In particular, thin film transistor 40 includes a first deposited conductive layer 42 formed over deposition substrate 41. A deposited dielectric layer 43 is formed over first conductive layer 42. A second deposited conductive layer 44 defining source electrode 45 and drain electrode 46 is formed over deposited dielectric layer 43. A deposited active layer 47, such as a deposited semiconductor layer, or a deposited organic semiconductor layer is formed over second deposited conductive layer 44.

Deposition techniques using mask set 20, represent the method of creating thin film transistor 40. In that case, each layer of thin film transistor 40 may be defined by one or more deposition apertures in non-metallic deposition masks 10 that form mask set 20.

By forming deposition apertures 14 in masks 10 to be sufficiently small, one or more features of thin film transistor 40 can be made less than 20 µm (microns), less than 10 µm (microns), or even less than 5 µm (microns). Moreover, by forming a gap in an aperture mask to be sufficiently small, other features such as the distance between source electrode 45 and drain electrode 46 can be made less than 20 µm (microns) or even less than 10 µm (microns). In that case, a single mask may be used to deposit second conductive layer 44, with each of the two electrodes 45, 46 being defined by deposition apertures separated by a sufficiently small gap, such as a gap less than 20 µm (microns) or a gap less than 10 µm (microns). In this manner, the size of thin film transistor 40 can be reduced, enabling fabrication of smaller, higher density circuitry while maintaining the performance of thin film transistor 40.

FIG. 5 illustrates another a thin film transistor 50. In particular, thin film transistor 50 includes a first deposited conductive layer 52 formed over deposition substrate 51. A deposited dielectric layer 53 is formed over first conductive layer 52. A deposited active layer 54, such as a deposited semiconductor layer, or a deposited organic semiconductor layer is formed over deposited dielectric layer 53. A second deposited conductive layer 55 defining source electrode 56 and drain electrode 57 is formed over deposited active layer 54.

Again, by forming deposition apertures 14 in masks 10 to be sufficiently small, one or more features of thin film transistor 50 can have widths on the order of those discussed herein. Also, by forming a gap in an aperture mask to be sufficiently small, the distance between source electrode 56 and drain electrode 57 can be on the order of the gaps discussed herein. In that case, a single mask may be used to deposit second conductive layer 55, with each of the two electrodes 56, 57 being defined by deposition apertures separated by a sufficiently small gap. In this manner, the size of thin film transistor 50 can be reduced, and in some cases the performance of thin film transistor 50 may even be improved.

Thin film transistors implementing organic semiconductors generally take the form of FIG. 4 because organic semiconductors typically cannot be etched or lithographically patterned without damaging or degrading the performance of the organic semiconductor material. For instance, morphological changes can occur in an organic semiconductor layer upon exposure to processing solvents. For this reason, fabrication techniques in which the organic semiconductor is deposited as a top layer are typically used. The configuration of FIG. 4 may be used if the active layer is any type of semiconductor. The configuration of FIG. 5 is advantageous because depositing appropriate source and drain electrodes on the organic semiconductor provides low-resistance interfaces.

By forming at least the top two layers of the thin film transistor using aperture mask deposition techniques, the invention can facilitate the configuration of FIG. 5, even if active layer 54 is an organic semiconductor layer. The configuration of FIG. 5 can promote improved growth of the organic semiconductor layer by allowing the organic semiconductor layer to be deposited over the relatively flat surface of dielectric layer 53, as opposed to being deposited over the non-continuous second conductive layer 44 as illustrated in FIG. 4. For example, if the organic semiconductor material is deposited over a non-flat surface, growth can be inhibited. Thus, to avoid inhibited organic semiconductor growth and high resistance interfaces, the configuration of FIG. 5 may be desirable. All of the layers of an integrated circuit are deposited as described above according to the invention.

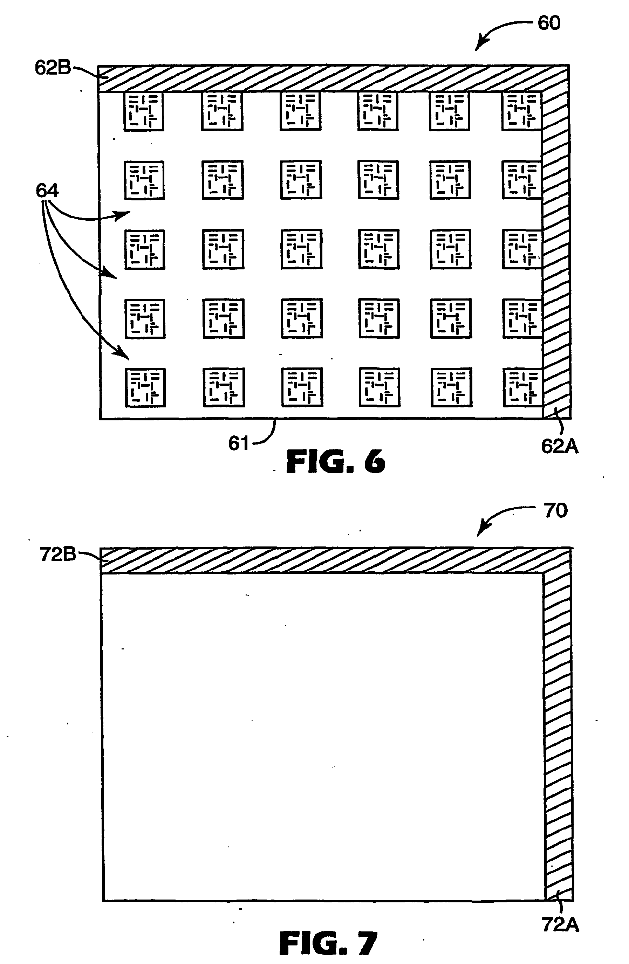

FIGS. 6 and 7 are top views of an aperture mask (FIG. 6) and a deposition substrate (FIG. 7), both having alignment edges.

One significant challenge to circuit fabrication using aperture mask deposition techniques relates to the difficulty in aligning the aperture masks with deposited layers on the deposition substrate. In particular, mechanical alignment of the aperture mask with the deposition substrate is extremely challenging when creating circuit elements having the dimensions described herein. Moreover, as more and more layers of a circuit are deposited, the alignment problem is compounded.

As shown in FIG. 6, an aperture mask 60 comprises a mask substrate 61 having alignment edges 62A and 62B (hereafter alignment edges 62). A pattern 64 of deposition apertures is defined in mask substrate 61 in relation to alignment edges 62 such that spatial alignment of the edges of mask substrate 61 aligns pattern 64 for the deposition process. Moreover, if each mask 10 in mask set 20 (FIG. 2) is formed with the same alignment edges, the masks can be easily aligned relative to deposited layers during sequential depositions.

FIG. 7 illustrates the corresponding deposition substrate 70 for use with the aperture mask of FIG. 6. As shown, deposition substrate 70 includes alignment edges 72A and 72B (hereafter alignment edges 72) that substantially correspond to the alignment edges 62 of the aperture mask illustrated in FIG. 6. In this manner, spatial alignment of the edges of aperture mask of FIG. 6 and the edges of deposition substrate 70 of FIG. 7, properly aligns pattern 64 relative to deposition substrate 70 for the deposition process. Furthermore, as mentioned above, if each mask in a mask set has similar alignment edges, alignment of each mask relative to deposited layers can be easily achieved in sequential depositions.

The formation of alignment edges on mask 60 avoids the need for registration holes and posts, which can introduce slight clearances that permit movement and can result in misalignment. Moreover, for non-metallic masks, the use of registration holes and posts can even cause damage to the mask, particularly as efforts are made to provide a tight fit that reduces clearances in the holes. Accordingly, the use of alignment edges 62 can be more effective in aligning aperture mask 60 than registration holes. In some cases, the use of alignment edges 62 can facilitate mechanical alignment of aperture mask 60 and deposition substrate 70 to within a tolerance less than approximately 10 µm (microns), less than approximately 5 µm (microns), or even less than approximately 2 µm (microns). The invention can avoid mask damage and facilitate precise alignment for the formation of circuits created in the deposition process.

A number of aperture masks including alignment edges may form a mask set, in which case each aperture mask may include similar alignment edges but different patterns defined in relation to the alignment edges. In this manner, each aperture mask in the mask set can be properly aligned with deposition substrate 70 by aligning the edges of each mask with the edges of deposition substrate 70.

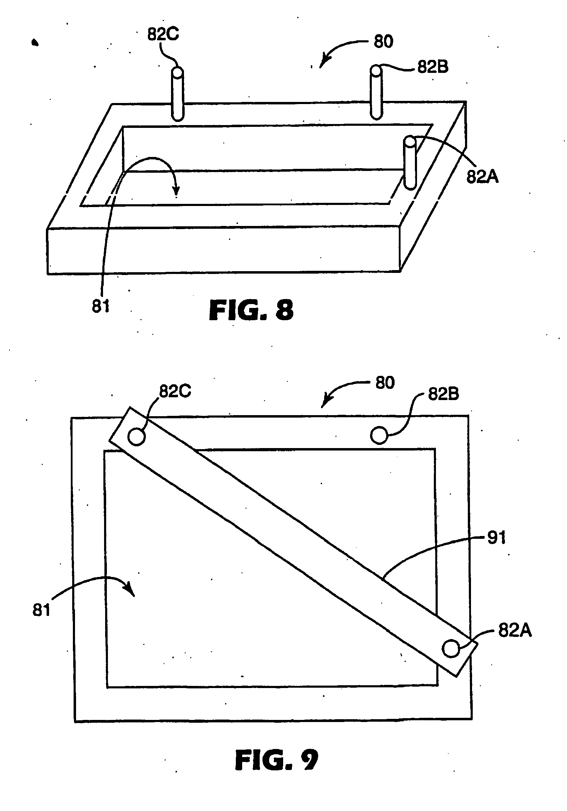

FIG. 8 is a perspective view of an alignment fixture. In particular, alignment fixture 80 can facilitate quick and accurate alignment of aperture masks and deposition substrates that include alignment edges. Alignment fixture includes a relatively large deposition hole 81. An aperture mask can cover deposition hole 81 and a deposition substrate can be placed into intimate contact with the aperture mask. Material can be vaporized up through deposition hole 81, and deposited on the deposition substrate according to the pattern defined in the aperture mask.

Alignment fixture 80 includes at least three contact points 82A, 82B and 82C. The contact points 82A, 82B and 82C are illustrated as forming pins, but other configurations of contact points 82, such as posts, bumps and the like are also envisioned. The aperture mask having alignment edges and the deposition substrate having alignment edges can be placed into alignment fixture 80 such that the alignment edges of both the aperture mask and the deposition substrate contact alignment fixture 80 at exactly the three contact points 82A, 82B and 82C. In this manner, quick and precise alignment can be achieved, in some cases, to a tolerance less than approximately 10 µm (microns) less than approximately 5 µm (microns), or even less than approximately 2 µm (microns). In other cases, additional contact points can be added to define exactly three different contact points for a different deposition.

Alignment fixture 80 is capable of providing precise alignment without the need for alignment posts that extend through registration holes in the aperture mask and the deposition substrate. Moreover, alignment fixture 80 is capable of avoiding the slight movement that may occur with the use of alignment posts that extend through registration holes. In particular, alignment fixture 80 does not rely on alignment holes in the mask, which can be slightly larger than the alignment posts. Additionally, temperature differentials can compound problems associated with alignment posts that extend through registration holes in a mask.

The alignment edges used with alignment fixture 80 help to achieve precise alignment without the problems associated with registration holes and posts that extend through the holes. Also, the simplicity of the alignment fixture 80 can also allow aperture masks and deposition substrates to be aligned more quickly, decreasing production costs and increasing throughput of a large-scale manufacturing process for some applications.

FIG. 9 is a top view of an embodiment of an alignment fixture 80. As shown in FIG. 9, alignment fixture 80 may include additional features to ensure that a deposition substrate and an aperture mask can be properly secured into alignment. In particular, alignment fixture 80 may include a securing element 91 to secure the aperture mask and the deposition substrate into alignment. Also, securing element 91 may exert a spring bias to force the aperture mask and the deposition substrate against alignment fixture 80. A spring bias force may be exerted through a securing element 91 or through separate elements. In either case, alignment can be maintained and intimate contact assured during the deposition process.

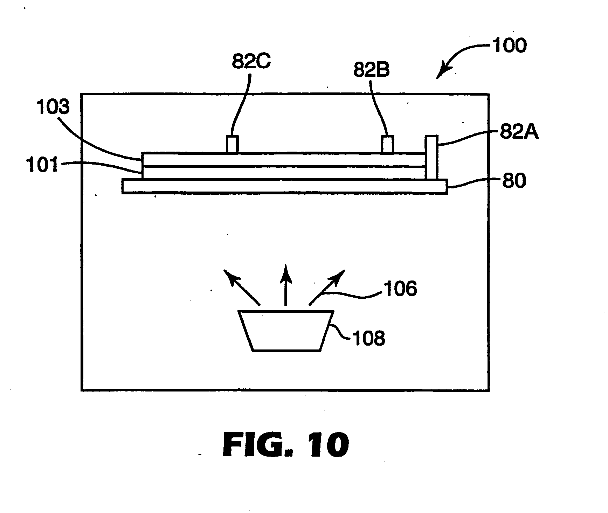

FIG. 10 is a simplified a block diagram of a deposition station according to the invention. Deposition station 100 can perform a vapor deposition process in which material is vaporized, deposited and accumulated on a deposition substrate through an aperture mask. Aperture mask 101 is placed in proximity or into intimate contact with a deposition substrate 103 within alignment fixture 80. Both the aperture mask 101 and the deposition substrate 103 include alignment edges. Thus, the pattern in aperture mask 101 is properly aligned with deposition substrate 103 simply by ensuring that the edges of both aperture mask 101 and deposition substrate 103 contact the three contact points 82A, 82B and 82C.

Deposition station 100 is typically a vacuum chamber. After aperture mask 101 is placed in proximity or into intimate contact with a deposition substrate 103 within alignment fixture 80, material 106 is vaporized by deposition unit 108. For example, deposition unit 108 may include a boat of material that is heated to vaporize the material. The vaporized material 106 passes through hole 81 (not shown in FIG. 10) and deposits on deposition substrate 103 through the deposition apertures of aperture mask 101 to define at least a portion of a circuit layer on deposition substrate 103. Again, aperture mask 101 may include deposition apertures and gaps that are sufficiently small. The combination of the small aperture sizes in aperture mask 101, the small gaps between adjacent apertures in aperture mask 101, and the precision alignment that can be achieved using alignment fixture 80 and alignment edges on aperture mask 101 and deposition substrate 103, can facilitate the creation of circuits having circuit features of widths less than approximately 20 µm (microns), less than approximately 10 µm (microns) or less than approximately 5 µm (microns).

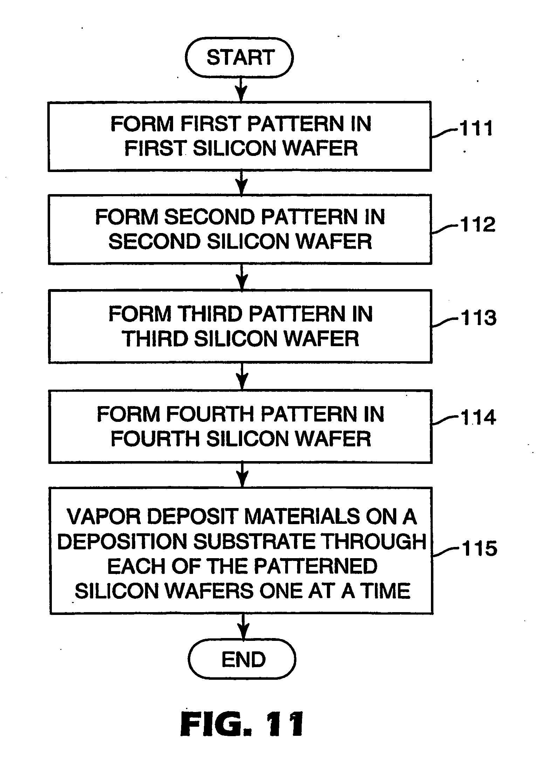

FIGS. 11-13 are flow diagrams. shown in FIG. 11, a method of fabricating aperture masks includes forming a first pattern in a first silicon wafer (111) and forming a second pattern in a second silicon wafer (112). Additionally, a third pattern is formed in a third silicon wafer (113) and a fourth pattern is formed in a fourth silicon wafer (114). Moreover, circuit element widths less than approximately 20 µm (microns), 10 µm (microns), or even 5 µm (microns) can be achieved as described above.

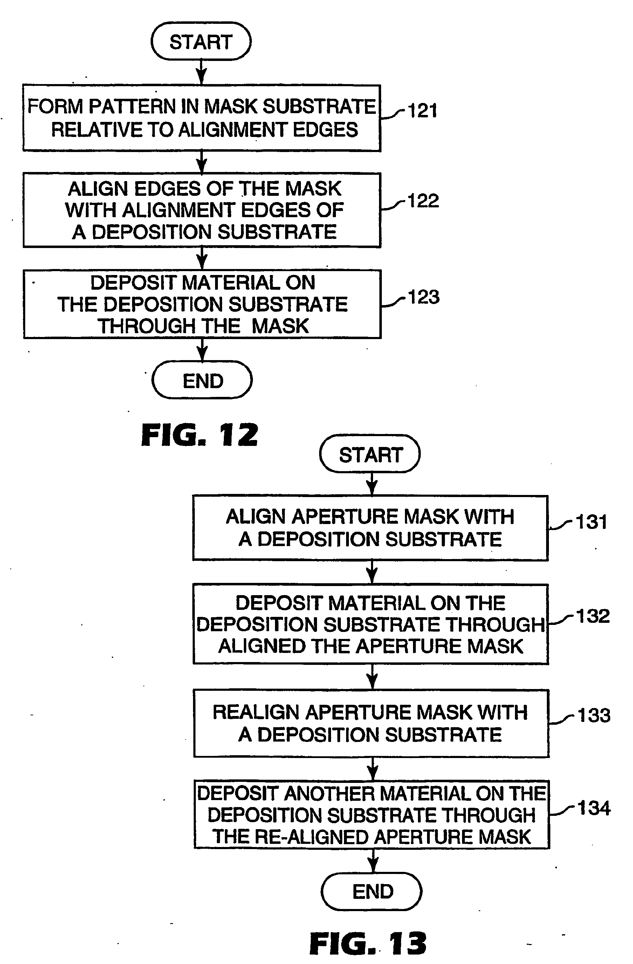

FIG. 12 illustrates a process of forming and using an aperture mask that includes forming a pattern in a mask substrate relative to alignment edges to define an aperture mask (121). The pattern can then be aligned with a deposition substrate by aligning the alignment edges of the mask with alignment edges of the deposition substrate (122). In other words, the edges 62 of mask 60 and the edges 72 of deposition substrate 70 are pushed against the three contact points 82A, 82B and 82C of alignment fixture 80 until they abut, and then securing mechanism 91 can lock mask 60 in place.

After proper alignment is achieved, material can be deposited on the deposition substrate through the aperture mask (123). In this manner, aperture mask deposition techniques can be used to achieve circuit elements having relatively small widths. In particular, relatively small deposition aperture widths and relatively small gaps between deposition apertures, together with the use of the precision alignment techniques described herein can achieve deposition circuits having very small feature widths.

In one example, patterns are formed in masks for sequential depositions in which the pattern of the first aperture mask forms a gate electrode and wherein the material deposited onto the deposition substrate through the pattern of the second aperture mask is a semiconductor, the semiconductor being deposited after the gate electrode is deposited. In that case, source and drain electrodes can be deposited onto the semiconductor through the pattern of a third aperture mask.

In another example, patterns are formed in masks for sequential depositions in which the pattern of the first aperture mask forms a gate electrode, wherein the material deposited onto the deposition substrate through the pattern of the second aperture mask forms a dielectric layer. In that case, a semiconductor can be deposited onto the dielectric layer through the pattern of a third aperture mask, and source and drain electrodes can be deposited onto the semiconductor through the pattern of a fourth aperture mask. For each deposition, the pattern of the respective aperture mask can be positioned relative to the deposition substrate by positioning the alignment edges of the respective aperture mask and the alignment edges of the deposition substrate in contact with the exactly three contact points of alignment fixture 80.

FIG. 13 illustrates another method. As shown, a method of forming a circuit element includes aligning an aperture mask with a deposition substrate (131). Material is then deposited on the substrate through the aligned aperture mask (132). The aperture mask is then realigned with the deposition substrate (133), and another material is deposited on the substrate through the realigned aperture mask (134).

The method of FIG. 13 can be particularly useful when a single circuit layer requires a number of similarly shaped features consisting of different materials. In one example, the active layers of complimentary thin film transistor circuit elements can be created by depositing through an aligned aperture mask, a hole-conducting semiconductor material suitable for p-channel thin film transistors. The aperture mask can then be realigned and an electron-conducting semiconductor material suitable for n-channel thin film transistors can be deposited through the realigned aperture mask. In this manner, the p-channel and n-channel semiconductor materials are deposited for the active layer of a complimentary thin film transistor circuit element. A number of complimentary thin film transistor circuit elements can be formed by patterning an array in the aperture mask.

In other examples, a first light emitting material can be deposited, the aperture mask realigned, and then a second light emitting material can be deposited. For example, the mask may be aligned for three separate depositions, corresponding the red, green and blue sub-pixels. In that case, the three depositions may define a pixel for a display. The deposited materials may be organic or inorganic. In some cases, one material may be organic and another may be inorganic. A similar process may be used to make colored sub-pixels using color filter material for use in a display or a sensor.

In one example, alignment edges of the aperture mask and deposition substrate can be used to facilitate realignment. For example, the deposition substrate may define alignment edges that are slightly different on the various sides of the deposition substrate. In that case, realignment may comprise removing the aperture mask from the alignment fixture, rotating the aperture mask (such as by a quarter turn) and then reinserting the rotated aperture mask into the alignment fixture. In other words, a first material can be deposited though the aperture mask formed with alignment edges, and the aperture mask can be rotated relative to the deposition substrate. A second material can then be deposited through the aperture mask. The different alignment edges, such as alignment edges 62A and 62B (FIG. 6) may be slightly different so that deposition of the first and second materials results in deposited material on the deposition substrate in slightly different locations. Alternatively, an alignment structure can be created such that the deposition substrate can be fixed in a constant location, but the aperture mask can be fixed in a number of locations.

### EXAMPLE

Organic integrated circuits were fabricated using four vacuum deposition steps and four thin (50 µm (micrometer)thick) single crystal silicon masks. Four silicon masks were fabricated simultaneously by processing a single photolithographically patterned silicon water in a deep trench etcher (PlasmaTherm SLR Series using inductively coupled plasma). Four separate patterns were defined, one on each quadrant of the single wafer, and each pattern had with it associated alignment edges located in the same position relative to each pattern to allow rapid mechanical alignment using 3 point contact on 2 flat edges to within a tolerance of 10 µm (micrometers) or less. Each pattern (and corresponding alignment edges) was etched through the wafer to form vias. Each of the resulting aperture masks was patterned to form a separate deposited device layer as follows: (1) gate metal, (2) insulator, (3) semiconductor, and (4) source/drain metal.

After the aperture masks were formed, integrated circuits were fabricated by vapor deposition using no photolithography or wet processing. A first aperture mask was placed on an alignment fixture like that illustrated in FIGS. 8 and 9. A substrate was placed over the aperture mask on the alignment fixture with one edge of the substrate contacting two of the contact points of the alignment fixture and a second edge of the substrate contacting the third contact point. A securing element attached to two of contact points was used to hold the substrate and mask in position during the deposition process. Material was deposited through the first mask onto the substrate.

The first mask was removed and replaced by the second mask. The second mask was then aligned to the pattern on the substrate and the edges of the substrate by mechanically tapping the mask against the contact points of the alignment fixture and affixing the securing element to hold the assembly securely in place. The second material was then deposited through the mask. The second mask was then replaced by the third mask, the mechanical alignment was repeated, and the third material was deposited through the mask. Finally the third mask was replaced by the fourth, alignment was repeated, and the fourth material was deposited through the mask. The fourth mask was then removed, at which stage the circuit component was complete. Interconnections between circuit components were made by "stitching" traces in the gate and source/drain layers.

Using the above four masks, seven-stage pentacene ring oscillators were fabricated on glass substrates and tested. Palladium (50 nm thick) was vapor deposited as the gate metal, aluminum oxide (150 nm thick) as the insulator layer, pentacene (50 nm thick) as the semiconductor, and palladium (50 nm thick) as the source/drain layer. In this example, the integrated circuit was designed with minimum line widths of 15 micrometers. Performance of the resulting ring oscillator was evaluated at a test voltage of -30V, and the oscillator was found to be functional.

A number of embodiments of the invention have been described.

## Claims

1. A method of making an integrated circuit comprising:
forming a patterned first electrode layer adjacent a deposition substrate;
forming a patterned organic semiconductor layer adjacent the first electrode layer; and
depositing a patterned second electrode layer adjacent the organic semiconductor layer, wherein each patterned layer is defined by a repositionable aperture mask, wherein the patterned organic semiconductor layer is positioned between the patterned first electrode layer and the patterned second electrode layer.

2. The method of claim 1, wherein the patterned first electrode layer defines a gate electrode, and wherein the second patterned electrode layer defines source and drain electrodes.

3. The method of claim 1, wherein the patterned first electrode layer defines source and drain electrodes, and wherein the patterned second electrode layer defines a gate electrode.

4. The method of claim 1, further comprising forming a patterned dielectric layer adjacent the organize semiconductor layer.

5. The method of claim 1, wherein the integrated circuit forms at least part of a circuit selected from the following group of circuits: an electronic display, a radio frequency identification (RFID) circuit, and an electronic memory.

6. A method of making a transistor comprising:
depositing a first patterned conductive layer;
forming a patterned dielectric layer over the deposited conductive layer;
forming a patterned organic semiconductor layer over the deposited dielectric layer; and
forming a second patterned conductive layer over the deposited organic semiconductor layer, wherein each patterned layer is defined by a repositionable aperture mask.

7. The method of claim 6, wherein the transistor forms at least part of an integrated circuit.

8. The method of claim 6, wherein the transistor forms at least part of a radio frequency identification (RFID) circuit.

## Patentansprüche

1. Verfahren für die Herstellung eines integrierten Schaltkreises, mit:
Bilden einer strukturierten ersten Elektrodenschicht neben einem Abscheidungssubstrat;
Bilden einer strukturierten organischen Halbleiterschicht neben der ersten Elektrodenschicht; und
Abscheiden einer strukturierten zweiten Elektrodenschicht neben der organischen Halbleiterschicht, wobei jede strukturierte Schicht durch eine umpositionierbare Lochmaske definiert ist, wobei die strukturierte organische Halbleiterschicht zwischen der strukturierten ersten Elektrodenschicht und der strukturierten zweiten Elektrodenschicht positioniert ist.

2. Verfahren nach Anspruch 1, wobei die strukturierte erste Elektrodenschicht eine Gate-Elektrode definiert und wobei die zweite strukturierte Elektrodenschicht eine Source- und Drain-Elektrode definiert.

3. Verfahren nach Anspruch 1, wobei die strukturierte erste Elektrodenschicht eine Source- und Drain-Elektrode definiert und wobei die strukturierte zweite Elektrodenschicht eine Gate-Elektrode definiert.

4. Verfahren nach Anspruch 1, ferner mit Bilden einer strukturierten dielektrischen Schicht neben der organischen Halbleiterschicht.

5. Verfahren nach Anspruch 1, wobei der integrierte Schaltkreis zumindest einen Teil eines Schaltkreises bildet, der aus der folgenden Gruppe von Schaltkreisen ausgewählt ist: einer elektronischen Anzeige, einem Radiofrequenz-Identifizierungsschaltkreis (RFID-Schaltkreis) und einem elektronischen Speicher.

6. Verfahren zur Herstellung eines Transistors, mit:
Abscheiden einer ersten strukturierten leitfähigen Schicht;
Bilden einer strukturierten dielektrischen Schicht über der abgeschiedenen leitfähigen Schicht;
Bilden einer strukturierten organischen Halbleiterschicht über der abgeschiedenen dielektrischen Schicht; und
Bilden einer zweiten strukturierten leitfähigen Schicht über der abgeschiedenen organischen Halbleiterschicht, wobei jede strukturierte Schicht durch eine umpositionierbare Lochmaske definiert ist.

7. Verfahren nach Anspruch 6, wobei der Transistor zumindest ein Teil eines integrierten Schaltkreises bildet.

8. Verfahren nach Anspruch 6, wobei der Transistor zumindest ein Teil eines Radiofrequenz-Identifizierungsschaltkreises (RFID-Schaltkreises) bildet.

## Revendications

1. Procédé de fabrication d'un circuit intégré comprenant :
la formation d'une première couche d'électrode à motifs contiguë à un substrat de dépôt ;
la formation d'une couche semi-conductrice organique à motifs contiguë à la première couche d'électrode ; et
le dépôt d'une seconde couche d'électrode à motifs contiguë à la couche semi-conductrice organique,
dans lequel chaque couche à motifs est définie par un masque perforé repositionnable, la couche semi-conductrice organique à motifs étant positionnée entre la première couche d'électrode à motifs et la seconde couche d'électrode à motifs.

2. Procédé selon la revendication 1, dans lequel la première couche d'électrode à motifs définit une électrode de grille, et dans lequel la seconde couche d'électrode à motifs définit des électrodes de source et de drain.

3. Procédé selon la revendication 1, dans lequel la première couche d'électrode à motifs définit des électrodes de source et de drain, et dans lequel la seconde couche d'électrode à motifs définit une électrode de grille.

4. Procédé selon la revendication 1, comprenant en outre la formation d'une couche diélectrique à motifs contiguë à la couche semi-conductrice organique.

5. Procédé selon la revendication 1, le circuit intégré formant au moins une partie d'un circuit choisi dans le groupe suivant de circuits : un affichage électronique, un circuit d'identification par radiofréquence (RFID), et une mémoire électronique.

6. Procédé de fabrication d'un transistor comprenant :
le dépôt d'une première couche conductrice à motifs ;
la formation d'une couche diélectrique à motifs par-dessus la couche conductrice déposée ;
la formation d'une couche semi-conductrice organique à motifs par-dessus la couche diélectrique déposée ; et
la formation d'une seconde couche conductrice à motifs par-dessus la couche semi-conductrice organique déposée,
dans lequel chaque couche à motifs est définie par un masque perforé repositionnable.

7. Procédé selon la revendication 6, dans lequel le transistor forme au moins une partie d'un circuit intégré.

8. Procédé selon la revendication 6, dans lequel le transistor forme au moins une partie d'un circuit d'identification par radiofréquence (RFID).
